# EUROPÄISCHE PATENTSCHRIFT

(11) **EP 2 974 023 B1**
(45) Veröffentlichungstag und Bekanntmachung des Hinweises auf die Patenterteilung: **13.05.2020**
(21) Anmeldenummer: 14710528.2
(22) Anmeldetag: 12.03.2014
(51) Int. Cl.: H03K 17/955

(54) **KAPAZITIVE SENSORANORDNUNG MIT SCHIRMELEKTRODE**
CAPACITIVE SENSOR ASSEMBLY HAVING A SHIELDING ELECTRODE
ENSEMBLE DE DÉTECTION CAPACITIVE ÉQUIPÉ D'UNE ÉLECTRODE DE PROTECTION

(30) Priorität: 12.03.2013 DE 102013102469
(43) Veröffentlichungstag der Anmeldung: 20.01.2016
(73) Patentinhaber: Huf Hülsbeck & Fürst GmbH & Co. KG, 42551 Velbert (DE)
(72) Erfinder: VAN GASTEL, Peter, 42699 Solingen (DE); RAULIN, Sebastian, 45147 Essen (DE)
(74) Vertreter: Zenz Patentanwälte Partnerschaft mbB
(86) Internationale Anmeldenummer: PCT/EP2014/054823
(87) Internationale Veröffentlichungsnummer: WO 2014/140089

(56) Entgegenhaltungen:
- WO-A1-2006/025003
- US-A1- 2008 136 792
- US-A1- 2010 295 559

## Beschreibung

Die Erfindung betrifft eine Sensoranordnung zur Detektion einer Annäherung und einer Bediengeste eines Benutzers. Insbesondere betrifft die Erfindung eine Sensoranordnung mit einer Sensorauswerteschaltung und Steuerschaltung, die mit wenigstens zwei Sensorelektroden gekoppelt ist. Die Sensorelektroden sind Teil eines kapazitiven Sensors zum Erfassen einer Annäherung eines Objekts. Dazu ist die Sensorauswerte- und Steuerschaltung zur Erfassung der Kapazität der Sensorelektroden ausgebildet. Eine Schirmelektrode ist ebenfalls mit der Steuerschaltung gekoppelt, so dass die Steuerschaltung das Potential der Schirmelektrode einstellen kann.

Kapazitive Sensoranordnungen der eingangs genannten Art sind im Bereich der Fahrzeugtechnik bekannt. Die Grundprinzipien eines kapazitiven Sensors sind auch in der US 5,730,165 offenbart.

Beispielsweise werden kapazitive Sensoreinrichtungen der eingangs genannten Art verwendet, um die Annäherung einer Hand eines Benutzers an einen Türaußengriff eines Fahrzeuges zu erfassen. Diese Erfassung erfolgt, ohne dass der Benutzer den Türgriff tatsächlich berührt. Kapazitive Annäherungssensoren sind der EP 1 339 025 A1 oder der EP 1 235 190 zu entnehmen. Kapazitive Sensoranordnungen werden auch bei Einklemmschutzvorrichtungen bei Kraftfahrzeugen eingesetzt. Die EP 1 164 240 A2 oder auch die DE 10 2006 044 778 beschreiben entsprechende kapazitive Einklemmschutzvorrichtungen.

Meist wird bei kapazitiven Sensoren eine Änderung der Kapazität der Sensorelektrode gegenüber einer Referenz detektiert. Eine entsprechende Messschaltung ist im Stand der Technik bereits in verschiedenen Ausführungen im Markt zu erwerben. Beispielsweise ist eine Messschaltung zum Messen der Kapazität einer Sensorelektrode gegenüber Masse auch der DE 196 81 725 zu entnehmen.

Ein Problem bei den kapazitiven Annäherungssensoren ist die für einige Bedienaktivitäten wenig spezifische Erfassung.

Das Dokument US 2008/0136792 A1 offenbart eine Anordnung von kapazitiven Schaltern, welche einen verbesserten Schutz vor Fehlerkennungen in feuchten Umgebungen bieten.

Während die Annäherung einer Hand an einen Türgriff regelmäßig einen Zugriff auf die Tür signalisiert und dann mit einer weiteren Autorisierungsabfrage gekoppelt ist, sind Bedienungen von anderen Fahrzeugfunktionen nicht in gleicher Weise eindeutig zu detektieren. Beispielsweise sind kapazitive Sensoren auch bei der Öffnung eines Kofferraums von einem Fahrzeug einzusetzen. Dabei wird mit einem Fuß eine Schwenk- oder Kickbewegung unter einem Heckbereich des Fahrzeuges ausgeführt. Hierbei ist die verlässliche Detektion eines tatsächlichen Bedienwillens besonders wichtig, da ansonsten beispielsweise vorbeirollende Gegenstände, Tiere oder Passanten eine Bedienung auslösen können.

Einerseits ist also eine ausreichende Sensitivität der Sensoreinrichtung zu gewährleisten, andererseits eine verlässliche Auswertung der Signaldaten hinsichtlich eines tatsächlichen Bedienwillens. Um die Empfindlichkeit von kapazitiven Sensoren zu verbessern und die Sensorreichweite zu vergrößern wurde vorgeschlagen, zwischen Sensorelektrode und der kraftfahrzeugseitig dahinter angeordneten Massefläche eine Abschirmung vorzunehmen. Diese Abschirmung kann aktiv als sogenanntes "Shielding" ausgeführt werden. Die dazu verwendete Elektrode wird als Schildelektrode oder auch Richtelektrode bezeichnet. Das Potential dieser abschirmenden Metallfläche kann gegenüber der eigentlichen Sensorelektrode eingestellt werden und wird oft mittels einer Spannungsverfolgerschaltung dem Potential der Sensorelektrode nachgeführt, also insbesondere identisch eingestellt. Die Schildwirkung wird entfaltet, da die elektrischen Feldlinien durch das veränderte Potentialumfeld der Sensorelektrode verstärkt in den erwünschten Sensierungsbereich erweitert werden. Eine derartige aktive Abschirmung ist beispielsweise der EP 0 518 836 A1 zu entnehmen.

Wesentlich ist, dass zwar Schildelektrode und Sensorelektrode dasselbe Potential aufweisen können, zur Sensierung jedoch nur die Signale der Sensorelektrode ausgewertet werden.

Aus der US 2010/0295559 A1 ist eine Einrichtung zur Erfassung von Annäherungen bekannt, welche eine Matrixanordnung einer Vielzahl von Elektroden aufweist, die in ihrer Funktion als Sensorelektrode oder Schirmelektrode schaltbar sind.

Die Druckschrift WO 2006/025003 A1 beschreibt einen Annäherungssensor für Röntgenapparate mit mehreren Elektroden, von denen wenigstens eine als Sensor und ein als Schirmelektrode wirkt.

Aufgabe der Erfindung ist es, eine sensitive Elektrodenanordnung auszubilden, welche eine verbesserte Gestenerkennung ermöglicht.

Die Aufgabe wird erfindungsgemäß durch eine kapazitive Sensoranordnung mit den Merkmalen des Patentanspruches 1 gelöst. Die erfindungsgemäße Sensoranordnung weist mehrere Sensorelektroden auf, die in einer Ebene angeordnet sind. Die Sensorelektroden sind also flächig oder auch beispielsweise als Leiterstruktur angeordnet, jedoch beide Sensorelektroden im Wesentlichen in derselben räumlichen Ebene. Die Sensorelektroden sind versetzt zueinander angeordnet, also ohne Überlappung und ohne elektrisch leitenden unmittelbarem Kontakt. Die Ebene, in welche diese Sensorelektroden angeordneten sind wird im Weiteren als Sensorebene bezeichnet. Die Sensorelektroden weisen in der Ebene einen Abstand auf. Innerhalb des Bereichs der diesen Abstand bildet ist eine weitere Elektrode angeordnet, die einen Abschnitt der Schirmelektrode bildet. Die Schirmelektrode ist also zwischen den Sensoren angeordnet, in der Sensorebene oder versetzt zu dieser.

Diese Anordnung hat den Vorteil, dass zwischen den Sensoren ein Bereich des elektrischen Feldes gebildet wird, der zwar durch das Potential der Schirmelektrode in diesen Bereich beeinflusst wird, jedoch nicht zur Sensierung beiträgt. Sensiert werden nur die Effekte, die von den zur Schirmelektrode beidseitig versetzten Sensorelektroden ausgehen. Die Detektionsfelder der beiden Sensorelektroden werden durch die dazwischen angeordnete Schirmelektrode getrennt. Eine Beeinflussung der Kapazität eines Sensorelektrodenabschnitts führt zu einer signifikanten Änderung der Kapazität der unterliegenden Sensorelektrode, nicht jedoch der anderen Sensorelektrode, da zwischen den Elektroden die Schirmelektrode in derselben Ebene angeordnet ist.

Wird also eine derartige Elektrodenanordnung für eine Bediengestenerkennung eingesetzt, so kann eine Kapazitätsbeeinflussung entlang der Elektrodenanordnung sensitiver erkannt werden. Liegen in einer Ebene beispielsweise von links nach rechts in der Abfolge ein Sensorelektrodenabschnitt, mit geringem Abstand dazu ein Schirmelektrodenabschnitt und mit weiteren geringen Abstand dazu in derselben Ebene ein weiterer Sensorelektrodenabschnitt, so kann beispielsweise eine Wischbewegung in dieser Richtung, also über erste Sensorelektrode, dann Schirmelektrode und schließlich zweite Sensorelektrode gut erfasst werden. Die Trennung durch die Schirmelektrode führt nämlich zu einer Verbesserten Differenzierung, weil in dem Bereich ein für die Detektion nahezu unsichtbarer Todbereich gebildet ist.

Während in der Phase, in der eine Hand oder ein Finger über den ersten Sensorelektrodenabschnitt geführt wird, in diesem Abschnitt eine wesentliche Kapazitätsänderung hervorruft, ist der Sensor für die Phase, in der der Finger über die Schirmelektrode geführt wird, wesentlich unempfindlicher. Die Kapazitätswerte bewegen sich in dieser Phase wieder stark in Richtung der unbeeinflussten Sensoranordnung. Wenn der Finger weitergeführt wird, erreicht er die zweite Sensorelektrode und die Kapazität dieser wird deutlich verändert. Durch diese Erkennung der zeitlichen Abfolge ist eine Betätigungserkennung in besonders verlässlicher Weise möglich.

Gemäß der Erfindung wird also die Schirmelektrode mit Ihrer Anordnung zwischen den Sensorelektroden nicht verwendet, um den sensitiven Bereich zu vergrößern, sondern um die sensitiven Bereiche zu trennen.

Erfindungswesentlich ist, dass sich die Schirmelektrode auf den Bereich zwischen den Sensorelektrodenabschnitten erstreckt. Die Schirmelektrode kann dabei durch auch mehrteilig aufgebaut sein und weitere Schirmabschnitte, beispielsweise unterhalb der Sensorelektroden, also auf der einer Detektion abgewandten Seite aufweisen.

Zwischen dem Sensorelektrodenabschnitten kann die Schirmelektroden in derselben Ebene wie die Sensoren angeordnet sein, dies ist jedoch nicht zwingend erforderlich, sie kann auch aus der Ebene heraus in Richtung des Detektionsbereiches oder zurückversetzt sein.

In einer bevorzugten Ausführungsform der Erfindung ist die Schirmelektrode in der Sensorebene zwischen den Sensorelektroden angeordnet. Dies erlaubt eine besonders einfache Fertigung, da die Sensorelektroden dann beispielsweise als Leitbereiche oder Leiterbahnen in derselben Platinenebene ausgebildet sein können.

Gemäß einer vorteilhaften Ausführungsform ist außerdem die erfindungsgemäße Einrichtung mit einer Mehrlagenplatine ausgebildet, wobei eine der Ebenen der Mehrlagenplatine die Sensorebene bildet. Die Sensorelektrodenabschnitte sind beispielsweise als metallische Bereiche in einer solchen Platinenebene ausgebildet, die in herkömmlicher Weise gefertigt sein kann. Die Schirmelektrode kann als getrennter Leitbereich in derselben Ebene zwischen den Sensorelektrodenflächen ausgebildet sein.

Es ist erfindungsgemäß möglich, dass die Sensorelektrodenabschnitte zwar durch die Schirmelektrode getrennt angeordnet sind, jedoch gemeinsam mit der Steuer- und Auswerteschaltung gekoppelt sind. Es ist in diesem Fall keine getrennte Erfassung der Sensorelektrodenabschnitte vorgesehen, vielmehr wird die Sensorelektrode mit mehreren Abschnitten gebildet, wobei beide Abschnitte durch einen Schirmelektrodenabschnitt getrennt sind.

Vorzugsweise werden die Sensorelektrodenabschnitte jedoch getrennt mit der Steuer- und Auswerteschaltung gekoppelt und ausgewertet. Dies erlaubt eine differenziertere Analyse der Betätigungssignale.

Grundsätzlich sind auch weitere Sensorelektrodenbereiche, die durch weitere Schirmelektrodenbereiche getrennt sind, möglich.

In einer bevorzugten Ausführungsform ist hinter den Sensorelektroden bei einer Mehrlagenplatine eine weitere Schicht mit Schirmelektroden gebildet. Außerdem kann vorgesehen sein, eine Masseelektrode auszubilden, vorzugsweise in einer Ebene der Mehrlagenplatine, welche der Detektionsrichtung abgewandt ist, hinter den Schirmelektrodenebenen.

Üblicherweise ist die Steuer- und Auswerteeinrichtung derart eingestellt, dass sie das Potential der Schirmelektrode identisch zu dem Potential der Sensorelektrode einstellt. Es kann jedoch auch vorgesehen sein, dass Potential der Schirmelektrode zur Beeinflussung der Sensitivität anders einzustellen. Die Trennung der Wirkung der Schirmelektrode zwischen den Sensorelektroden wird noch verstärkt, wenn das Potential der Schirmelektrode das Potential der Sensorelektrode bei gleichnamigem Potential übersteigt.

Für die Auswertung und die Auslegung der Steuer- und Auswerteschaltung wesentlich ist, dass eine Zeitfolge der Sensorsignale ausgewertet wird. Eine Abfrage des Sensors erfolgt zyklisch, beispielsweise mit einer Zyklusdauer von einigen zehn Millisekunden (z.B. 40 ms). Wird zu irgendeinem Zeitpunkt eine signifikante Kapazitätsänderung an einem Elektrodenabschnitt erfasst, so wird anschließend in vorgegebenen, ggf. geringeren Zeitabständen geprüft, ob die Sensorsignale eine Bediengeste signalisieren. Dies ist dann der Fall, wenn zunächst einer der Abschnitte der Sensorelektrode betätigt wird, dann ein Signal erfasst wird, welches die Bewegung einer bedienenden Hand oder eines bedienenden Fußes durch den Bereich der Schirmelektrode signalisiert und schließlich ein Signal erfasst wird, welches die Bewegung des bedienenden Körperteils durch den anderen Elektrodenbereich anzeigt. Genau den genannten Übergangsbereich schärft die erfindungsgemäße Einrichtung und verbessert damit die Detektion.

Werden die Sensorelektrodenabschnitte getrennt ausgewertet, so zeigt zunächst der erste Sensorelektrodenabschnitt eine signifikante Kapazitätsänderung. Innerhalb eines vorgegebenen Zeitraumes muss dann auch der zweite Sensorelektrodenabschnitt eine signifikante Kapazitätsänderung zeigen. Schließlich muss innerhalb eines weiteren vorgegebenen Zeitraumes eine Kapazitätsänderung im zweiten Abschnitt noch erfassbar sein, im ersten jedoch verschwunden sein. Die verbesserte Trennung der Auslösung der Sensorelektrodenabschnitte wird durch die dazwischen befindliche Schirmelektrode ermöglicht. Ansonsten wäre bei üblicher Größengestaltung eines Sensors und dem übrigen Potentialen immer der Fall gegeben, dass beide nebeneinander angeordneten Sensorkapazitäten durch einen Bedienerkörperteil beeinflusst werden. Nur die Trennung durch die Schirmelektrode ermöglicht es, die Sensorpotentiale zum Erhalt einer guten Sensitivität zu wählen und gleichzeitig eine Auslösung einer Sensorelektrode ohne Auslösung der anderen Sensorelektrode und damit zur zeitlichen Differenzierung zu ermöglichen.

Die Erfindung wird nun anhand eines Ausführungsbeispiels näher erläutert.
Die Figuren 1a bis 1c zeigen die schematische Anordnung von Elektroden einer Mehrschichtplatine gemäß der Erfindung.
Die Figur 2 zeigt schematisch die gestapelte Anordnung der Lagen der Mehrschichtplatine gemäß der Erfindung in einer explodierten perspektivischen Ansicht.
Die Figur 3 zeigt schematisch die gestapelte Anordnung der Lagen der Mehrschichtplatine gemäß der Erfindung in einer Aufsicht.

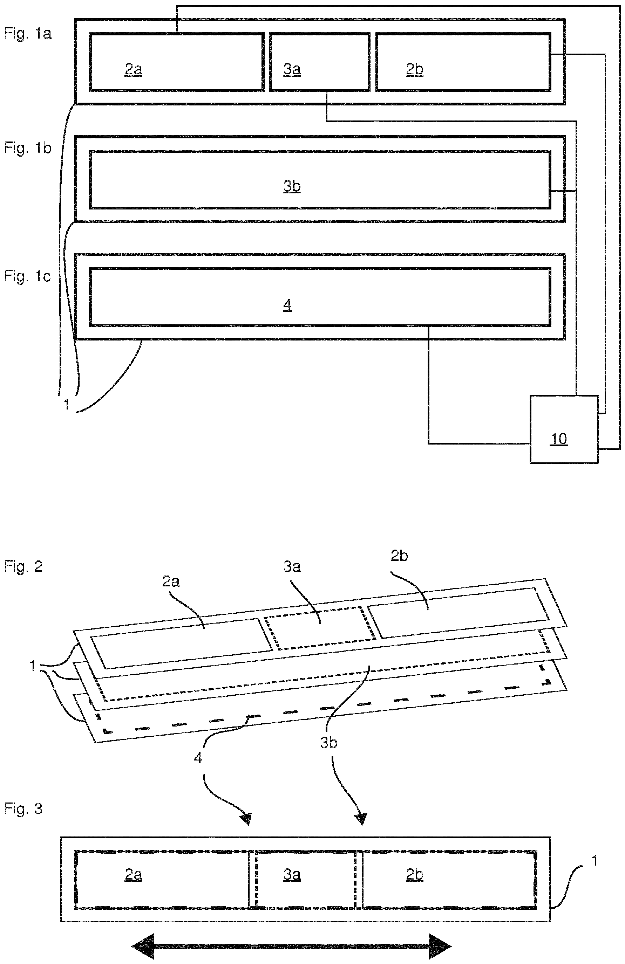

Die in Figur 1a dargestellte Ebene ist die äußere Ebene der Mehrschichtelektrodenplatine. Dies ist die Ebene, welche auf der dem Detektionsbereich zugewandten Seite liegt. Auf dieser Ebene der Platine 1 sind seitlich zwei Sensorelektroden 2a und 2b angeordnet. Die Sensorelektroden 2a und 2b sind als Kupferleitflächen auf der Platine in der üblichen Weise aufgebracht. Zwischen den Elektroden 2a und 2b ist ein Elektrodenbereich etwa gleicher Breite aber mit kürzerer Länge 3a gebildet. Dieser Bereich ist ein Abschnitt der Schirmelektrode. Die Steuerschaltung 10 ist mit den Sensorelektroden 2a und 2b zur getrennten Potentialvorgabe und Kapazitätsabfrage gekoppelt. Dazu verfügt die Steuer- und Auswerteschaltung 10 über die oben genannten und im Stand der Technik bekannten Schalteinrichtungen, welche die Kapazität beispielsweise durch Umladung der Elektroden zyklisch ermitteln. Außerdem ist die Elektrode 3a als Schirmelektrode mit der Steuer- und Auswerteeinrichtung gekoppelt, um das Potential der Schirmelektrode 3a gleich dem der Elektrodenabschnitte 2a und 2b vorzugeben. Die Kapazitätsänderung der Elektrode 3a wird jedoch durch die Steuer- und Auswerteschaltung nicht erfasst.

In Figur 1b ist eine tieferliegende Ebene der Mehrlagenplatine 1 gezeigt, wobei eine durchgehende Elektrodenfläche 3b gebildet ist. Diese ist zusammen mit dem Elektrodenabschnitt 3a mit der Steuer- und Auswerteschaltung 10 gekoppelt. Sie bildet einen weiteren Abschnitt der Schirmelektrode, der sich in eine nach hinten versetzte Ebene auch hinter den Sensorelektroden 2a und 2b erstreckt. Hinter den Elektroden 2a, 3a und 2b ist damit eine durchgehende Elektrodenfläche 3b als Schirmelektrode ausgebildet. Die Schirmelektrode 3a bildet damit einen Elektrodenabschnitt der gesamten Schirmelektrode (3a, 3b) wobei sowohl Abschnitte in der Sensorebene vorgesehen sind (Abschnitt 3a) als auch in einer dahinter liegenden Ebene (Abschnitt 3b).

Figur 1c zeigt einen noch weiter nach hinten versetzten Bereich der Mehrlagenplatine 1. Dort ist eine Elektrodenerstreckung mit ähnlichen Abmessungen wie die Elektrode 3b ausgebildet, jedoch als Masseelektrode 4. Auch diese Masseelektrode ist mit der Steuer- und Auswerteschaltung 10 gekoppelt.

Figur 2 zeigt schematisch die Anordnung der Lagen aus Figur 1 in der Mehrschichtplatine. Die verschiedenen Elektroden sind zur besseren Erkennung durch unterschiedliche Randbegrenzungen dargestellt. Die Sensorelektroden 2a und 2b sind mit durchgezogenen Linien dargestellt. Die Schirmelektrode (3a, 3b) ist mit einer gebrochenen Linie einer ersten Stärke dargestellt, die Masseelektrode 4 ist durch eine gebrochene Linie mit größeren Lücken einer zweiten Stärke dargestellt.

Figur 3 zeigt die Ansicht aus Figur 2 in einer Aufsicht, wobei die unterschiedlichen Überlappungen der Elektroden durch Erkennbarkeit der verschiedenen Randbegrenzungen deutlich werden. Es wird erkennbar, dass hinter den Sensorelektroden 2a und 2b sowohl eine Schirmelektrode, als auch eine dahinter befindliche Masseelektrode liegt. Zwischen den Sensorelektroden liegt eine Schirmelektrode 3a in einer ersten Lage, ein weiterer Abschnitt der Schirmelektrode 3b einer zweiten Lage und schließlich die Masseelektrode.

In Figur 3 ist außerdem erkennbar, wie die erfindungsgemäße Anordnung zur Detektierung einer Bewegung in Richtung des Doppelpfeiles orientiert ist. Wird beispielsweise die Elektrodenanordnung zur Betätigung einer Motorhaube oder einer Kofferraumabdeckung unterhalb einer Kunststoffabdeckung angeordnet, so kann ein Bediener mit seiner Hand über den Bedienbereich in Pfeilrichtung streichen (von links nach rechts oder in Gegenrichtung). Bei einem Überstreichen von links nach rechts wird zunächst eine Kapazitätsänderung des Elektrodenabschnittes 2a detektiert werden, sobald der Bediener in dem sensitiven Bereich der Elektrode 2a eindringt. Die Elektrode 2b ist zu diesem Zeitpunkt noch von der Bediengeste weitestgehend unbeeinflusst, da die zwischenliegende Schirmelektrode 3a den Einfluss des Bedieners auf den Elektrodenbereich 2b verhindert. Führt der Bediener seine Geste weiter durch, bewegt er seine Hand entlang der Elektrodenerstreckung von links nach rechts. Befindet sich die Hand etwa in der Mitte, etwa über der Schirmelektrode 3a, so werden beide Sensorelektroden 2a und 2b beeinflusst, was sich in einer Kapazitätsänderung beider Sensorelektrodenabschnitte zeigt. Schließlich verschwindet der Einfluss auf den linken Elektrodenbereich, da der Bediener seine Bewegung per Hand zum rechten Elektrodenbereich fortsetzt, so dass schließlich nur noch eine Beeinflussung des Abschnittes 2b vorliegt.

Diese Signalwechsel der Kapazitäten an den Elektroden 2a und 2b finden in einem vorgegebenen Zeitschema statt. Dazu wird in der Steuer- und Auswerteschaltung hinterlegt, welche Signaländerungszeiten für eine Bediengeste charakteristisch und akzeptabel sind. Beispielsweise kann hinterlegt sein, dass die gesamte Bedienungserkennung innerhalb von einer Sekunde abgeschlossen sein muss. Innerhalb dieser Sekunde muss eine charakteristische Signaländerung im Abschnitt 2a detektiert worden sein, dann muss gleichzeitig eine quantitativ vergleichbare Signaländerung in den Abschnitten 2a und 2b vorgelegen haben und schließlich muss eine ausschließliche Aktivierung des Bereichs 2b detektiert werden. Für jeden dieser Signalwechsel können zusätzliche zeitliche Signalspannen hinterlegt sein.

Die klare Trennung der Signaldetektion in den Abschnitten 2a und 2b ist möglich, da der zwischenliegende Abschnitt der Schirmelektrode 3b eine solche Trennung ermöglicht. Es sind auch andere Auswerteschemata möglich, wesentlich ist, dass erfindungsgemäß der zwischenliegende Schirmbereich eine bessere Differenzierung der Erfassungsbereiche der Sensorelektroden ermöglicht.

Im Rahmen der Erfindung sind Abwandlungen möglich, beispielsweise können weitere Abschnitte von Sensorelektroden und Schirmelektroden in derselben Sensorebene angeordnet werden.

## Patentansprüche

1. Sensoranordnung, mit
einer Sensorauswerte- und Steuerschaltung (10),
wenigstens zwei mit der Sensorauswerte- und Steuerschaltung (10) gekoppelten Sensorelektroden (2a, 2b) eines kapazitiven Sensors zum Erfassen einer Annäherung eines Objekts, wobei die Sensorauswerte- und Steuerschaltung (10) zur Erfassung der jeweiligen Kapazität der Sensorelektroden (2a, 2b) ausgebildet ist,
einer Schirmelektrode (3a, 3b), welche mit der Steuerschaltung (10) gekoppelt ist, wobei die Sensorauswerte- und Steuerschaltung (10) ausgebildet ist, um das Potential der Schirmelektrode einzustellen,
wobei wenigstens zwei Sensorelektroden (2a, 2b) in derselben Ebene beabstandet versetzt zueinander angeordnet sind und wobei zwischen den wenigstens zwei Sensorelektroden in derselben Ebene ein Abschnitt (3a) der Schirmelektrode (3a, 3b) angeordnet ist,
wobei die Sensorelektroden und die Schirmelektrode als Leiterschicht auf einer Mehrlagenplatine (1) angeordnet sind, wobei die Sensorelektroden auf einer äußeren Deckebene der Mehrlagenplatine ausgebildet sind und in einer weiteren Ebene der Platine unterhalb der Sensorelektroden und der Schirmelektrode eine Masseelektrode (4) ausgebildet ist,
wobei einen weiteren Abschnitt (3b) der Schirmelektrode zwischen Sensorelektroden und Masseelektrode (4) ausgebildet ist.

2. Sensoranordnung nach Anspruch 1, wobei die Sensorauswerte- und Steuerschaltung (10) das Potenzial der Sensorelektroden (2a, 2b) und der Schirmelektrode (3a, 3b) identisch einstellt.

## Claims

1. A sensor arrangement, having
a sensor analysis and control circuit (10),
at least two sensor electrodes (2a, 2b) of a capacitive sensor, coupled to the sensor analysis and control circuit (10), for detecting an approach of an object, wherein the sensor analysis and control circuit (10) is constructed for detecting the respective capacitance of the sensor electrodes (2a, 2b),
a shield electrode (3a, 3b), which is coupled to the control circuit (10), wherein the sensor analysis and control circuit (10) is constructed for setting the potential of the shield electrode,
wherein at least two sensor electrodes (2a, 2b) are arranged spaced offset from one another in the same plane and wherein a section (3a) of the shield electrode (3a, 3b) is arranged between the at least two sensor electrodes in the same plane,
wherein the sensor electrodes and the shield electrode are arranged as a conductor layer on a multilayer printed circuit board (1), wherein the sensor electrodes are constructed on an outer top plane of the multilayer printed circuit board and an earth electrode (4) is constructed in a further plane of the printed circuit board below the sensor electrodes and the shield electrode,
wherein a further section (3b) of the shield electrode is constructed between sensor electrodes and earth electrode (4) .

2. The sensor arrangement according to Claim 1, wherein the sensor analysis and control circuit (10) sets the potential of the sensor electrodes (2a, 2b) and the shield electrode (3a, 3b) identically.

## Revendications

1. Ensemble de détection avec
un circuit d'évaluation et de commande de détection (10),
au moins deux électrodes de détection (2a, 2b) couplées au circuit d'évaluation et de commande de détection (10) d'un capteur capacitif pour saisir une approche d'un objet, sachant que le circuit d'évaluation et de commande de détection (10) est constitué pour la saisie de la capacité respective des électrodes de détection (2a, 2b),
une électrode de protection (3a, 3b), laquelle est couplée au circuit de commande (10), sachant que le circuit d'évaluation et de commande de détection (10) est constitué pour régler le potentiel de l'électrode de protection,
sachant qu'au moins deux électrodes de détection (2a, 2b) sont disposées dans le même plan décalées à distance l'une de l'autre, et sachant qu'entre au moins deux électrodes de détection dans le même plan est disposée une section (3a) de l'électrode de protection (3a, 3b),
sachant que les électrodes de détection et l'électrode de protection sont disposées en tant que couche de conducteurs sur une platine multicouche (1), sachant que les électrodes de détection sont constituées sur un plan de couverture extérieur de la platine multicouche et qu'une électrode de masse (4) est constituée dans un autre plan de la platine en dessous des électrodes de détection et de l'électrode de protection,
sachant qu'une autre section (3b) est constituée entre les électrodes de détection et l'électrode de masse (4).

2. Ensemble de détection selon la revendication 1, sachant que le circuit d'évaluation et de commande de détection (10) règle de façon identique le potentiel des électrodes de détection (2a, 2b) et de l'électrode de protection (3a, 3b)
